# DEMANDE DE BREVET EUROPEEN

(11) **EP 0 993 026 A1**
(43) Date de publication de la demande: **12.04.2000**
(21) Numéro de dépôt: 99402304.2
(22) Date de dépôt: 21.09.1999
(51) Int. Cl.: H01L 21/00

(54) **Dispositif autorisant le traitement d'un substrat dans une machine prévue pour traiter de plus grands substrats et système de montage d'un substrat dans ce dispositif**

(30) Priorité: 25.09.1998 FR 9812002
(71) Demandeur: COMMISSARIAT A L'ENERGIE ATOMIQUE, 75752 Paris Cédex 15 (FR)
(72) Inventeur: Jourde, Dominique, 38180 Seyssins (FR); Turc, Gérard, 38130 Echirolles (FR)
(74) Mandataire: Dubois-Chabert, Guy

(57) **Abrégé**

Dispositif autorisant le traitement d'un substrat dans une machine prévue pour traiter de plus grands substrats et système de montage d'un substrat dans ce dispositif.

Le dispositif comprend un anneau (24) ayant un diamètre extérieur égal au diamètre de ces substrats, cet anneau étant apte à sertir le substrat (22) de diamètre inférieur. Le système comprend des moyens (34) de manipulation de ce substrat et des moyens (36) de chauffage de l'anneau ou de refroidissement de ce substrat. Application en microélectronique.

## Description

### DOMAINE TECHNIQUE

La présente invention concerne un dispositif appelé « leurre », autorisant le traitement d'un substrat dans une machine prévue pour traiter de plus grands substrats ainsi qu'un système de montage d'un substrat dans ce dispositif.

Elle s'applique notamment en microélectronique, dans le cas du traitement de substrats semiconducteurs, par exemple des plaquettes (« wafers ») de silicium, ou de substrats en céramique qui sont par exemple destinés à la fabrication de dispositifs hyperfréquences.

### ÉTAT DE LA TECHNIQUE ANTÉRIEURE

Les machines destinées à traiter des plaquettes de silicium sont prévues pour traiter des plaquettes dont les diamètres sont choisis parmi un nombre limité de diamètres ou des plaquettes d'un unique diamètre. Lorsqu'on veut traiter des plaquettes ayant un diamètre inférieur à ce dernier il faut modifier ces machines.

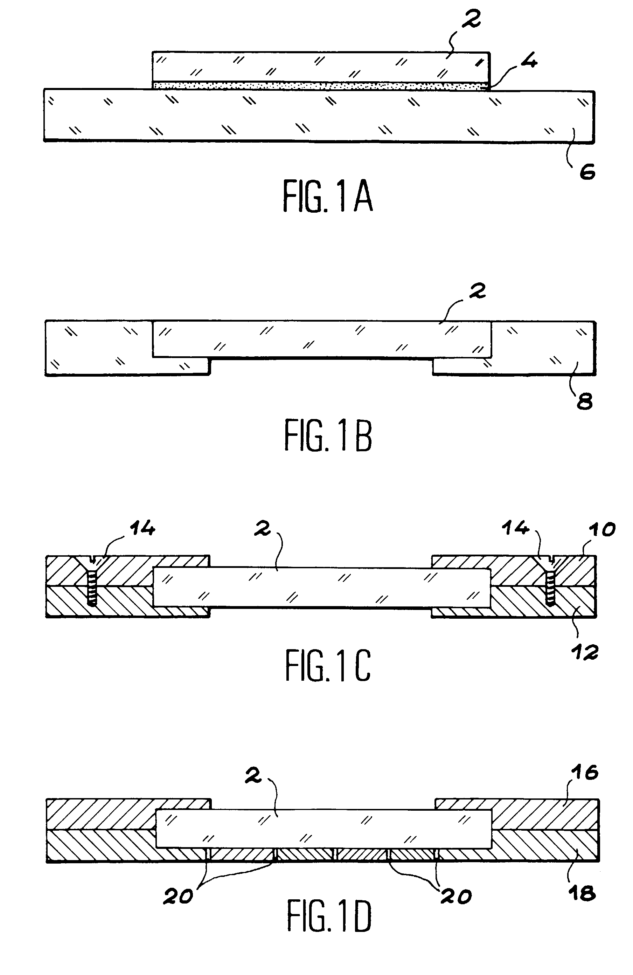

Il est également connu de fabriquer des leurres (figures 1A à 1D). Pour ce faire (figure 1A), une plaquette 2 de silicium ayant un diamètre inférieur à celui qui est accepté par une machine de traitement peut être fixée au moyen d'une couche de colle 4 sur une autre plaquette de silicium 6 ayant le diamètre accepté par la machine. Cependant le dégazage de la colle pollue la machine.

Il est également connu de poser la plaquette 2 dans un évidement à fond ouvert, formé dans une plaquette de silicium 8 ayant le diamètre accepté par la machine (voir la figure 1B). Mais cela pose un problème de transport du leurre ainsi obtenu vers cette machine car la plaquette 2 n'est pas tenue dans l'évidement. De ce fait, elle risque en outre d'être éjectée lorsqu'un plasma est formé dans la machine. Il est en outre connu (figure 1C) de maintenir la plaquette 2 dans un empilement de deux anneaux 10 et 12 serrés l'un contre l'autre par des vis 14, chaque anneau ayant un diamètre extérieur égal à celui qui est accepté par la machine. Cependant cette solution présente des inconvénients : l'empilement des anneaux 10 et 12 et l'immobilisation de la plaquette 2 dans ceux-ci sont trop difficiles à obtenir. La plaquette 2 risque d'être rayée et une pollution particulaire risque de se produire. Par ailleurs, si l'anneau 10 n'est pas suffisamment refroidi, il peut brûler les résines laquées sur la plaquette.

Il est aussi connu de maintenir la plaquette 2 dans une empilement de deux anneaux 16 et 18 (figure 1D) qui ne sont pas fixés l'un à l'autre et dont le diamètre extérieur est encore égal au diamètre accepté par la machine, le fond de l'anneau inférieur 18 étant fermé mais pourvu de petits trous 20 permettant le passage d'un gaz de traitement. Cependant cette solution présente l'inconvénient de nécessiter un anneau supérieur 16 ayant un poids suffisant pour empêcher l'éjection de la plaquette 2 lors d'un traitement par plasma de celle-ci, ce qui conduit à un assemblage trop lourd.

De plus, la pression de gaz caloporteur (par exemple l'hélium) engendre des pressions correspondant à l'application d'une force de l'ordre de 10N sur une plaquette de 100 mm de diamètre. Le poids de l'anneau 16 devrait donc être supérieur à cette valeur.

### EXPOSÉ DE L'INVENTION

La présente invention a pour but de remédier aux inconvénients précédents.

Elle a tout d'abord pour objet un dispositif autorisant le traitement d'un premier substrat sensiblement circulaire, ayant un premier diamètre, dans une machine prévue pour traiter des substrats sensiblement circulaires ayant un deuxième diamètre supérieur au premier diamètre, ce dispositif étant caractérisé en ce qu'il comprend un anneau apte à sertir le premier substrat, cet anneau étant fait d'un matériau qui est compatible avec les traitements mis en oeuvre dans la machine et ayant un diamètre extérieur égal au deuxième diamètre et un diamètre intérieur inférieur au premier diamètre, cet anneau étant apte à se dilater suffisamment par chauffage, ou le premier substrat étant apte à se contracter suffisamment par refroidissement, en vue du sertissage de ce premier substrat dans l'anneau.

De préférence, lorsque le premier substrat est un substrat de semiconducteur ou de céramique, l'anneau est apte à se dilater suffisamment par chauffage en vue dudit sertissage.

Lorsque le premier substrat est un substrat de silicium, on peut utiliser un anneau en aluminium anodisé ou en aluminium revêtu d'une couche de résine protectrice.

Selon un mode de réalisation préféré du dispositif objet de l'invention, l'anneau comprend un rebord interne apte à maintenir le premier substrat lors du traitement de celui-ci dans la machine.

De préférence également, pour que les contraintes susceptibles d'être appliquées au premier substrat soient les plus faibles possibles, l'anneau comprend un évidement formé tout le long de la paroi intérieure de cet anneau et ayant sensiblement une forme complémentaire de celle du bord du premier substrat, en vue de recevoir ce dernier.

Pour des questions de simplicité de fabrication, au lieu d'un tel évidement, il est préférable que l'anneau comprenne un évidement formé tout le long de la paroi intérieure de cet anneau et ayant, lorsque cette paroi intérieure est vue en coupe transversale, la forme d'un angle aigu dont un côté est perpendiculaire à l'axe de l'anneau et qui a une valeur suffisante pour recevoir le bord du premier substrat.

De préférence cet angle aigu vaut sensiblement 60°.

La présente invention concerne aussi un système de montage du premier substrat dans le dispositif objet de l'invention, caractérisé en ce qu'il comprend :
- des moyens de manipulation prévus pour mettre en place le premier substrat dans l'anneau et déplacer ce premier substrat lorsqu'il a été serti dans cet anneau et
- des moyens de chauffage de l'anneau ou de refroidissement du premier substrat afin de pouvoir sertir ce premier substrat dans l'anneau.

Dans le cas où le premier substrat est un substrat de semiconducteur ou de céramique, on utilise de préférence, comme on l'a vu plus haut, un anneau apte à se dilater suffisamment par chauffage en vue du sertissage. Dans ce cas, le système comprend des moyens de chauffage de l'anneau afin de pouvoir sertir ce premier substrat dans l'anneau. Ces moyens de chauffage peuvent comprendre une couronne escamotable ayant un diamètre extérieur au moins égal à celui de l'anneau et un diamètre intérieur qui est supérieur au diamètre du premier substrat, cette couronne comportant des résistances chauffantes. En complément des moyens de chauffage, on peut également prévoir des moyens destinés à refroidir l'anneau lorsque le premier substrat y a été mis en place.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figure 1A à 1D sont des vues en coupe transversale schématiques de leurres connus,
- les figures 2 à 5 sont des vues en coupe transversale schématiques de modes de réalisation particuliers du leurre objet de l'invention, et
- la figure 6 est une vue schématique d'un mode de réalisation particulier du système de montage objet de l'invention.

### EXPOSÉ DÉTAILLÉ DE MODES DE RÉALISATION PARTICULIERS

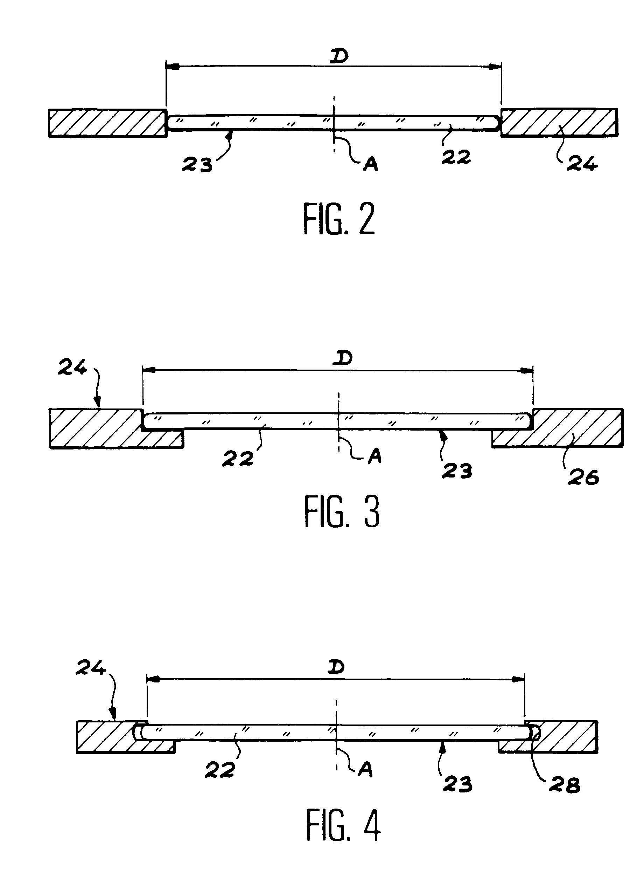

On considère un substrat formé par une plaquette de silicium 22 (figure 2) ayant un diamètre D1 (par exemple égal à 100 mm). On suppose que l'on veut traiter une face 23 (face active) de cette plaquette dans une machine (non représentée) prévue pour traiter des plaquettes de silicium ayant un diamètre D2 supérieur à D1, D2 étant par exemple égal à 200 mm. Conformément au principe de la présente invention, la plaquette 22 est tenue par son bord, au moyen d'un dispositif appelé « leurre », prévu pour y insérer et en extraire cette plaquette sans contamination de la machine ni destruction du dispositif.

Ce dispositif conforme à l'invention comprend un anneau 24 dont le diamètre extérieur vaut D2 et dont le diamètre intérieur D est inférieur à D1. La plaquette 22 est sertie dans cet anneau 24, ce dernier étant fait d'un matériau compatible avec le traitement et apte à se dilater suffisamment par rapport au matériau de la plaquette. L'axe A est l'axe commun à la plaquette 22 et à l'anneau 24. L'ensemble formé par la plaquette 22 et l'anneau 24 a ainsi un diamètre D2 acceptable par la machine et peut donc être traité dans celle-ci, d'où le traitement de la plaquette 22. Cependant, il n'y a de tolérance possible avec le leurre de la figure 2 car soit la plaquette demeure contrainte soit elle sort de l'anneau lors d'un chauffage important au cours du traitement.

La figure 3 est une vue en coupe transversale schématique d'un autre dispositif conforme à l'invention qui améliore celui de la figure 2. Dans le cas de la figure 3, l'anneau 24 est pourvu d'un rebord interne 26 prévu pour maintenir la plaquette 22 lorsque celle-ci et l'anneau sont chauffés de façon importante au cours du traitement. On empêche ainsi la sortie de l'anneau lors de ce traitement. Ce rebord interne 26 sert également à masquer les méplats de la plaquette.

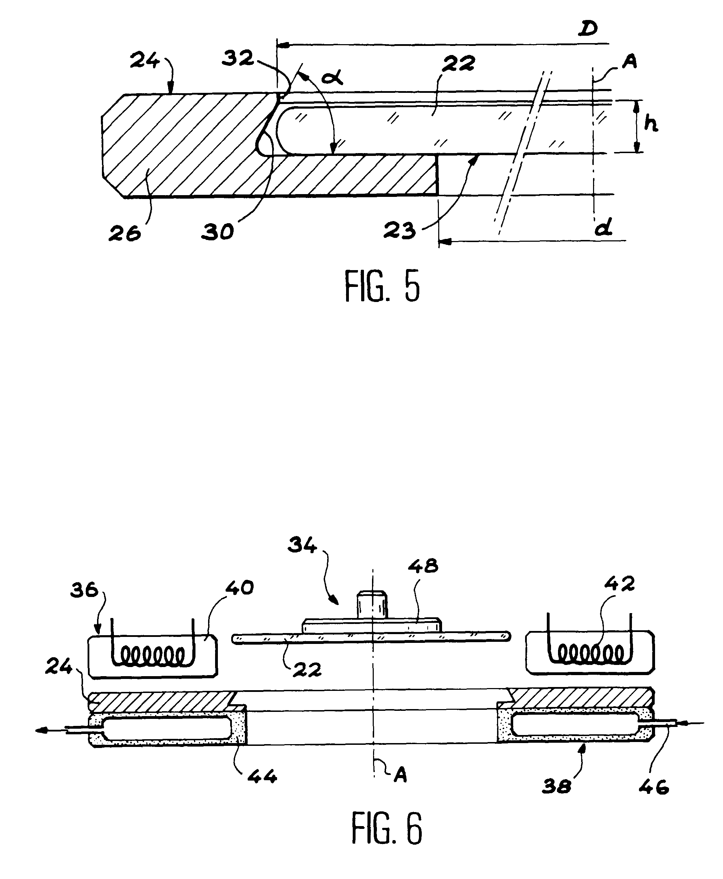

La figure 4 est une vue en coupe transversale schématique d'un autre dispositif conforme à l'invention qui améliore encore plus celui de la figure 2. Dans le cas de la figure 4, l'anneau comprend en outre un évidement 28 formé tout le long de la paroi intérieure de cet anneau et ayant sensiblement une forme complémentaire de celle du bord de la plaquette 22 (c'est-à-dire une forme concave arrondie dans l'exemple représenté). Cet évidement permet de réduire, voire d'éliminer, les contraintes susceptibles de s'exercer sur la plaquette. On voit qu'après sertissement de la plaquette, cette dernière pénètre dans cet évidement 28 lors du refroidissement de l'anneau. Pour simplifier la fabrication de l'anneau, on remplace de préférence l'évidement 28 par un évidement 30 ayant sensiblement, lorsqu'il est vu en coupe transversale, la forme d'un angle aigu α dont un côté est perpendiculaire à l'axe A de l'anneau et qui a une valeur suffisante pour recevoir le bord de la plaquette 22. Ceci est schématiquement illustré par la figure 5 qui est une vue en coupe transversale schématique et partielle d'un mode de réalisation préféré du dispositif objet de l'invention. De préférence, on réalise cet angle en formant un chanfrein à 60° (α = 60 %), ce qui donne un jeu suffisant à la plaquette 22.

On voit sur la figure 5 que le côté de l'angle, qui n'est pas perpendiculaire à l'axe A, se prolonge par un rebord 32 parallèle à cet axe A. Le diamètre de ce rebord 32 a une valeur D légèrement inférieure au diamètre de la plaquette (à la température ambiante de l'ordre de 20°C). En chauffant l'anneau 24 à plus de 100°C, cet anneau de dilate et l'on peut introduire dans celui-ci la plaquette 22 (à travers l'ouverture définie par le rebord 32). Après refroidissement, la plaquette est emprisonnée dans le logement limité par l'évidement 30 tout en étant maintenue par le rebord inférieur 26 qui empêche la plaquette de tomber lorsque cette plaquette est traitée dans la machine.

Le matériau choisi pour réaliser l'anneau 24 est rigide, dilatable, inerte vis-à-vis d'un plasma, faiblement déformable pour des températures de l'ordre de 200°C et inerte au gaz activé du plasma. On sait que l'aluminium est rigide et dilatable (coefficient de dilatation : 2,4 mm/m/100°C). Cependant, il n'est pas inerte à ce gaz ni au plasma. Le matériau alors choisi à titre d'exemple est l'aluminium anodisé ou l'aluminium protégé par une couche de résine.

A titre purement indicatif et nullement limitatif, avec une plaquette 22 de silicium de 100 mm ± 0,50 mm de diamètre, on utilise un anneau 24 en aluminium anodisé sur une épaisseur de 30 µm ou en aluminium revêtu d'une couche de résine identique à la résine laquée sur la plaquette, ou d'un dépôt d'une couche de matériaux compatibles avec le procédé et le plasma, de 1 µm d'épaisseur ; D = 99,90 mm ± 0,02 mm ; l'épaisseur de l'anneau 24 vaut 1 mm ; la distance h entre la face supérieure du rebord 26 et le plan qui délimite inférieurement le rebord 32 est très légèrement supérieure à l'épaisseur de la plaquette qui vaut 0,5 mm ; le diamètre de l'ouverture délimitée par le rebord interne inférieur 26 vaut 94 mm ; la masse de l'ensemble anneau-plaquette est de l'ordre de 60 g, masse qui est comparable à celle d'une plaquette de silicium de 200 mm de diamètre.

La figure 6 est une vue en coupe transversale schématique d'un système permettant le montage de la plaquette 22 dans l'anneau 24. Ce système comprend un robot 34 de manipulation de la plaquette et des moyens escamotables 36 de chauffage de l'anneau. Le système de la figure 6 comprend aussi des moyens 38 de refroidissement de l'anneau après chauffage de celui-ci. Dans l'exemple représenté, les moyens de chauffage 36 comprennent une couronne escamotable 40 ayant un diamètre extérieur au moins égal à celui de l'anneau et un diamètre intérieur supérieur à celui de la plaquette et pourvu de résistances électriques 42 de chauffage de l'anneau par effet Joule et les moyens de refroidissement 38 comprennent une sole de refroidissement 44 munie de moyens 46 pour y faire circuler un fluide (gaz ou liquide) réfrigérant.

Pour le montage de la plaquette 22 dans l'anneau 24 on commence par mettre en place cet anneau sur la sole 44. On amène ensuite la couronne de chauffage 40 en regard de cet anneau pour chauffer ce dernier qui se dilate. La plaquette 22 maintenue en dépression par des moyens appropriés 48 dont est pourvu le robot 34 est alors mise en place dans l'anneau. La couronne 36 est ensuite escamotée. On fait alors circuler le fluide réfrigérant dans la sole 38 pour refroidir l'anneau jusqu'à la température ambiante. Le robot 34 est ensuite utilisé pour emmener la plaquette montée dans l'anneau vers un moyen de stockage (non représenté).

Avec un substrat fait d'un matériau ayant un coefficient de contraction suffisant, au lieu de chauffer l'anneau, on peut refroidir le substrat de façon qu'après réchauffement à la température ambiante ce substrat soit serti dans l'anneau. Le système de montage du substrat dans l'anneau comprend dans ce cas un moyen de refroidissement du substrat. On met en contact le substrat avec ce moyen de refroidissement. Le substrat se contracte suffisamment pour qu'on puisse alors le mettre en place dans l'anneau. On réchauffe ensuite l'ensemble anneau-substrat pour le ramener à la température ambiante. Le substrat est alors maintenu dans l'anneau et peut être transporté par un robot de manipulation vers un moyen de stockage.

## Revendications

1. Dispositif autorisant le traitement d'un premier substrat sensiblement circulaire (22), ayant un premier diamètre, dans une machine prévue pour traiter des substrats sensiblement circulaires ayant un deuxième diamètre supérieur au premier diamètre, ce dispositif étant caractérisé en ce qu'il comprend un anneau (24) apte à sertir le premier substrat, cet anneau étant fait d'un matériau qui est compatible avec les traitements mis en oeuvre dans la machine et ayant un diamètre extérieur égal au deuxième diamètre et un diamètre intérieur inférieur au premier diamètre, cet anneau étant apte à se dilater suffisamment par chauffage, ou le premier substrat étant apte à se contracter suffisamment par refroidissement, en vue du sertissage de ce premier substrat dans l'anneau.

2. Dispositif selon la revendication 1, dans lequel le premier substrat (22) est un substrat de semiconducteur ou de céramique et l'anneau (24) est apte à se dilater suffisamment par chauffage en vue dudit sertissage.

3. Dispositif selon la revendication 2, dans lequel le premier substrat (22) est un substrat de silicium et l'anneau (24) est en aluminium anodisé ou en aluminium revêtu d'une couche de résine protectrice.

4. Dispositif selon l'une quelconque des revendications 1 à 3, dans lequel l'anneau (24) comprend un rebord interne (26) apte à maintenir le premier substrat (22) lors du traitement de celui-ci dans la machine.

5. Dispositif selon l'une quelconque des revendications 1 à 4, dans lequel l'anneau (24) comprend un évidement (28) formé tout le long de la paroi intérieure de cet anneau et ayant sensiblement une forme complémentaire de celle du bord du premier substrat (22), en vue de recevoir ce dernier.

6. Dispositif selon l'une quelconque des revendications 1 à 4, dans lequel l'anneau comprend un évidement (30) formé tout le long de la paroi intérieure de cet anneau et ayant sensiblement, lorsque cette paroi intérieure est vue en coupe transversale, la forme d'un angle aigu (α) dont un côté est perpendiculaire à l'axe de l'anneau et qui a une valeur suffisante pour recevoir le bord du premier substrat.

7. Dispositif selon la revendication 6, dans lequel l'angle aigu (a) vaut sensiblement 60°.

8. Système de montage du premier substrat dans le dispositif selon l'une quelconque des revendications 1 à 7, caractérisé en ce qu'il comprend :
- des moyens de manipulation (34) prévus pour mettre en place le premier substrat (22) dans l'anneau (24) et déplacer ce premier substrat lorsqu'il a été serti dans cet anneau et
- des moyens (36) de chauffage de l'anneau ou de refroidissement du premier substrat afin de pouvoir sertir ce premier substrat dans l'anneau.

9. Système de montage du premier substrat, dans le dispositif selon la revendication 2, caractérisé en ce qu'il comprend :
- des moyens de manipulation (34) prévus pour mettre en place le premier substrat (22) dans l'anneau (24) et déplacer ce premier substrat lorsqu'il a été serti dans cet anneau et
- des moyens (36) de chauffage de l'anneau afin de pourvoir sertir ce premier substrat dans l'anneau.

10. Système selon la revendication 9, dans lequel les moyens (36) de chauffage de l'anneau comprennent une couronne escamotable (40) ayant un diamètre extérieur au moins égal à celui de l'anneau et un diamètre intérieur qui est supérieur au diamètre du premier substrat, cette couronne comportant des résistances chauffantes (42).

11. Système selon l'une quelconque des revendications 9 et 10, comprenant en outre des moyens (38) destinés à refroidir l'anneau lorsque le premier substrat y a été mis en place.
